# EUROPEAN PATENT SPECIFICATION

(11) **EP 0 627 761 B1**
(45) Date of publication and mention of the grant of the patent: **21.11.2001**
(21) Application number: 94106664.9
(22) Date of filing: 28.04.1994
(51) Int. Cl.: H01L 21/20, H01L 21/331, H01L 29/73, H01L 29/76, H01L 21/337

(54) **Epitaxial overgrowth method and devices**
Verfahren zum epitaxialen Wachstum und Vorrichtungen
Méthode de croissance épitaxiale et dispositifs obtenus

(30) Priority: 30.04.1993 US 55421; 30.04.1993 US 56004; 30.04.1993 US 56681; 30.04.1993 US 56682
(43) Date of publication of application: 07.12.1994
(73) Proprietor: TEXAS INSTRUMENTS INCORPORATED, Dallas Texas 75265 (US)
(72) Inventor: Plumton, Donald L., Dallas, TX 75269 (US); Kim, Tae Seung, Dallas, TX 75248 (US); Yuan, Han-Tzong, Dallas, TX 75269 (US)
(74) Representative: Schwepfinger, Karl-Heinz, Dipl.-Ing.

(56) References cited:
- EP-A- 0 099 270
- EP-A- 0 450 274
- DE-A- 1 929 093
- PATENT ABSTRACTS OF JAPAN vol. 13, no. 166 (E-746) 20 April 1989 & JP-A-63 318 791 (NIPPON TELEGR. & TELEPH. CORP.) 27 December 1988
- PATENT ABSTRACTS OF JAPAN vol. 10, no. 186 (E-416) (2242) 28 June 1986 & JP-A-61 034 979 (RES.DEV.CORP. OF JAPAN) 19 February 1986

## Description

### BACKGROUND OF THE INVENTION

The invention relates to electronic semiconductor devices and circuits, and, more particularly, to methods of fabrication with epitaxial overgrowth and to a vertical field effect transistor of the type defined in the precharacterizing portion of claim 9 and further to a heterojunction bipolar transistor.

A semiconductor device of the type mentioned above is known from EP-A-0 099 270. This document discloses a method for the formation of buried gates in a semiconductor device using epitaxial growing method combined with diffusion method or diffusion by an additional heat treatment. The buried gate has smaller gate resistance by providing relatively high impurity concentration and also has good reverse characteristic by providing relatively low impurity concentration at the top of the buried gates.

Various semiconductor processing flows include formation of epitaxial layers on substrates. Such epilayers may provide a change in doping level, a crystal structure superior to that of the substrate, or even a change in material such as a gallium arsenide (GaAs) substrate with an aluminum gallium arsenide (AlₓGa₁₋ₓAs) epilayer for heterojunction devices. Epilayer growth by metal organic chemical vapor deposition (MOCVD) on {100} oriented GaAs substrates produces smoother surfaces when the substrate orientation is tilted 2° in the {110} direction, and industry standard GaAs wafers have such an orientation tilt. This tilt rovides a slightly terraced surface (terrace widths on the order of 0.01-0.02 µm (100-200 Å) which insures smooth epilayer growth.

Certain processing flows include epitaxial overgrowth of nonplanar structures. In particular, silicon bipolar transistor processes frequently have a buried layer formed by epitaxial overgrowth of a doped region which has been depressed below the substrate surface by an oxidizing drive-in cycle. But more significantly, heterojunction bipolar transistors (HBTs) and self-aligned structure (SAS) lasers can be fabricated with epitaxial growth over steps in a GaAs layer. See Plumton et al, Planar AlGaAs/GaAs HBT Fabricated by MOCVD Overgrowth with a Grown Base, 37 IEEE Trans. Elec. Dev. 118 (1990) (Growth of n-AlₓGa₁₋ₓAs emitter over p-GaAs base mesa for an HBT) and Noda et al, Effects of GaAs/AlAs superlattic buffer layers on selective area regrowth for GaAs/AlGaAs self-aligned structure lasers, 47 Appl. Phys. Lett. 1205 (1985) (Molecular beam epitaxy growth of p-AlₓGa₁₋ₓAs over n-GaAs antiguiding mesa for a SAS laser). However, such epitaxial overgrowth on step structures has problems including finding growth conditions for enhancing device performance.

Manufacture of III-V compound semiconductor optical wave guide element with embedded structure, which involves epitaxial growth on an horizontal plane of a step structure, is known from Patent Abstracts of Japan, Vol. 13, No. 166 (E-746), 20 April 1989 and JP-A-63318791. A stripe-shaped projecting section having a vertical sidewall with plane orientation equivalent to the crystallographical plane orientation a face 01-1 and a face 0-11 or the face 01-1 and the face 0-11 is formed on the cristallographical plane orientation, a face 100 or a plane equivalent to the face 100 on a substrate mainly consisting of III-V compound. Then, in a vapor phase or vacuum, at least, a crystalline layer mainly consisting of III-V compound to be an optical guide layer and a crystalline layer mainly consisting of III-V compound to be clad layers are epitaxially grown on the said plane.

DE-A-1 929 093 discloses a semiconductor diode comprising a substrate of GaAs monocrystal of one conductivity type having a surface oriented in the [100] crystal plane and an isolating passivation layer on the substrate surface. An octagonal hole in the passivation layer, which has sidewalls oriented in the [100] and [110] crystal planes of the substrate, reaches down to the substrate. A GaAs epilayer of the opposite conductivity type and having a thickness which is greater than that of the passivation layer covers the substrate within the hole and formes a pn junction with the substrate.

### SUMMARY OF THE INVENTION

The present invention provides epitaxial overgrowth with III-V compound semiconductors (compounds of elements from groups III and V of the periodic table) over steps in substrates with sidewalls having equivalent crystal plane orientation as the substrate surface.

According to one aspect of the present invention, there is provided a method of epitaxial overgrowth, comprising the steps defined in claim 1.

According to a second aspect of the present invention, there is provided a vertical field effect transistor, as defined in claim 9. of the type mentioned in the beginning and having the features of the characterizing portion of claim 9.

According to a third aspect of the present invention, there is provided a heterojunction bipolar transistor, as defined in claim 23.

### BRIEF DESCRIPTION OF THE DRAWINGS

Reference will now be made by way of example, to the accompanying drawings in which:
Figures 1 a-c are perspective and cross-sectional elevation and plan views of a first preferred embodiment vertical field effect transistor.
Figures 2 a-c show electrical characteristics and behavior of the first preferred embodiment.
Figures 3a, b and d illustrate applications of the first preferred embodiment.
Figure 3c illustrates a prior art application.
Figures 4a-d show steps in a first preferred embodiment method of fabrication.
Figure 5a is a plan view of a prior art embodiment.
Figures 5b-c are plan views of semiconductor substrates illustrating a step of the preferred embodiment method of fabrication.
Figures 6a-b show oriented substrates and epitaxial growth for the prior art and the invention respectively.
Figure 7 illustrates in cross sectional view a second preferred embodiment.
Figures 8a-b illustrate equipotentials of the second preferred embodiment.
Figures 9a-b show electrical characteristics of the second preferred embodiment.
Figure 10 is a cross sectional elevation view of a third preferred embodiment.
Figure 11 is a perspective view of a fourth preferred embodiment.
Figure 12 illustrates in cross sectional view a fifth preferred embodiment.
Figure 13 shows in cross sectional view a sixth preferred embodiment.

### DESCRIPTION OF THE PREFERRED EMBODIMENTS

### First preferred embodiment VFET

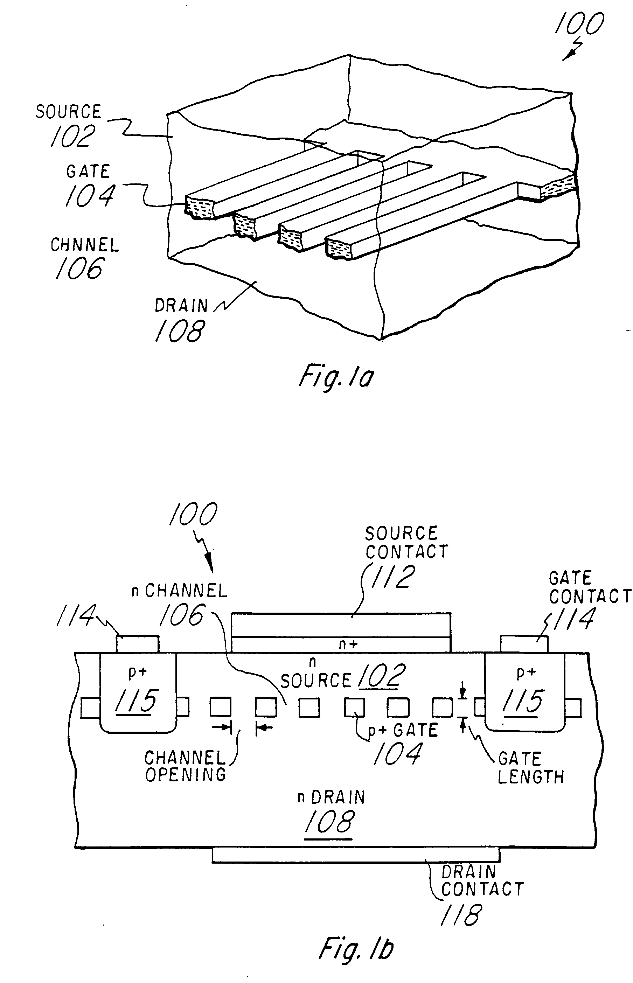

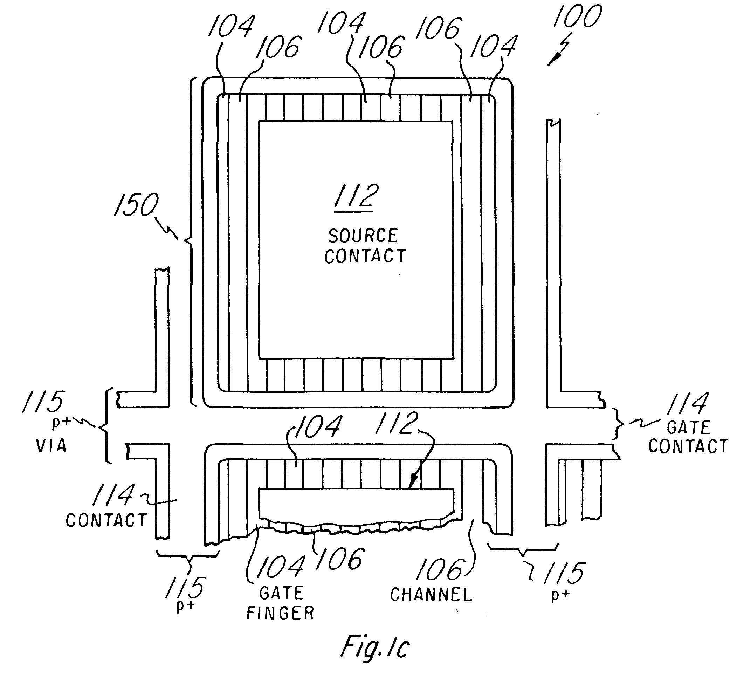

Figure 1a shows in cutaway perspective view a first preferred embodiment vertical field effect transistor (VFET), generally denoted by the reference numeral 100, made of gallium arsenide (GaAs) and including n doped source 102, p+ doped gate 104 in the form of parallel fingers with n doped channel regions 106 between successive gate fingers, and n doped drain 108 which includes a drift region. Figure 1b shows VFET 100 in cross sectional elevation view and also shows source contact 112, metal gate contact 114 which connects to gate 104 through p+ region 115, and bottom drain contact 118. Figure 1c heuristically shows a plan view and indicates that the array of parallel gate fingers and channels can be repeated to increase total gate and channel width while retaining low gate resistance because of the gate metal around each repeated cell 150. Alternatively, the drain contact could be taken to the top surface analogous to the collector in a vertical bipolar transistor structure; this would also permit use of a high resistivity substrate and integration of other devices without a common drain. Note that for clarity Figures 1b-c show only seven channel regions 106 between adjacent parallel p+ regions 115; more typically there would be about 100-200 channel regions between adjacent parallel p+ regions, and the overall size of the rectangular areas surrounded by p+ 115 would be 100 µm by 200 µm. The use of metal gate contact 114 strapping the entire p+ region 115 lowers the gate resistance for high frequency operation.

VFET 100 has the structure of parallel junction field effect transistors (JFETs) with current flowing vertically in Figures 1a-b. With a positive voltage V_{DS} applied from drain to source, majority carrier electrons flow from source 102 through channel regions 106 to drain 108; and a voltage V_{GS} applied to gate 104 (reverse bias of the p-n junction) controls this flow by modulating the carrier levels in channel regions 106. The gate length equals the channel length plus the associated p-n depletion region and is the vertical distance indicated in Figure 1b. The channel opening is the distance between adjacent gate fingers as shown in Figure 1b. VFET 100 has a channel length of 0.3 µm and a channel opening of 0.5 µm with a channel doping concentration of 3 x 10¹⁶ atoms/cm³.

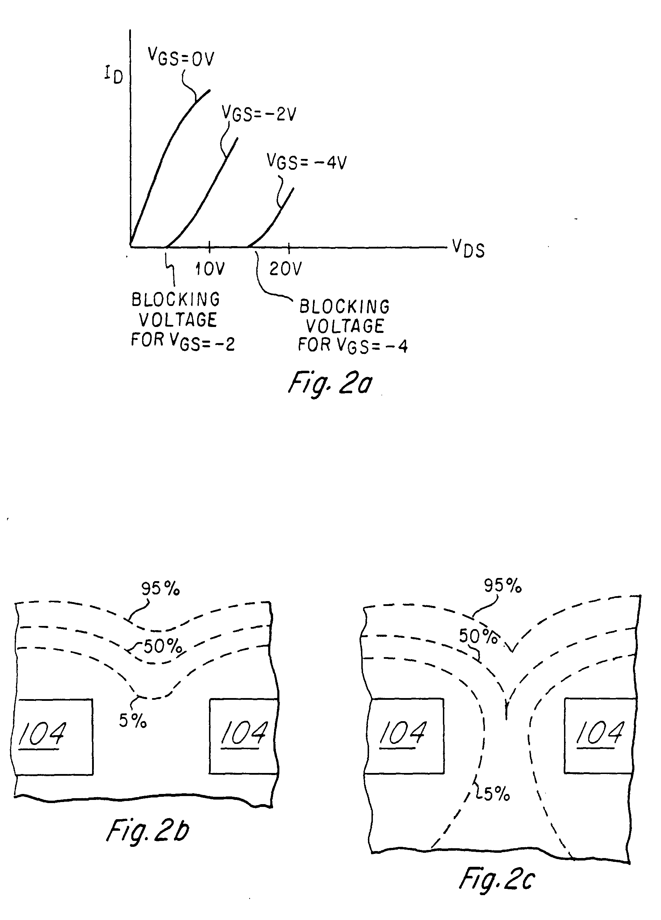

Figure 2a illustrates the electrical characteristics of VFET 100. For V_{GS} equal to 0, the depletion region of the p-n junction formed by gate 104 and channel 106 takes up about half of channel 106, and the drain current I_{D} is proportional to V_{DS} for small V_{DS} and flows through the undepleted neutral central portion of channel 106. The ratio I_{D}/V_{DS} is called the on-resistance R_{ON} and depends upon the channel material, geometry, doping level, substrate resistance, and contact resistance. The channel material resistivity equals roughly 25 micro-ohm-cm² for VFET 100 while for the entire VFET it is roughly 50-100 micro-ohm-cm².

As V_{GS} becomes negative and increases in magnitude, the neutral central channel portion begins to pinch off due to the reverse bias of the gate-channel junction, and the drain current pinches off. This represents the standard triodelike operation of a vertical JFET. Power switching applications only use turned-on and turned-off states of VFET 100. V_{GS}=0 (or V_{GS} positive to forward bias the gate-channel junction for current injection) will turn on VFET 100 and I_{D} will be large and V_{DS} will be small; whereas, V_{GS} large (negative) will turn off VFET 100 and I_{D} will be a leakage current and V_{DS} will be large. Thus the saturated current regime of pentodelike operation of a JFET will not typically be used.

With V_{GS}=-2 volts the gate-channel junction depletion regions fill up channels 106 and this allows only leakage drain current I_{D} until V_{DS} reaches a certain minimum value (the blocking voltage). Further increases in V_{DS} beyond the blocking voltge cause a rapid increase in drain current. The drain current follows a space charge limited dependence on V_{DS} and thus VFET 100 exhibits triodelike operation. Increasing | V_{GS} | increases the blocking voltage, and the ratio of blocking voltage to | V_{GS} | is the DC blocking gain. VFET 100 has a DC blocking gain of roughly 3 to 20 for V_{DS} in the range of 5 to 50 volts. Very high blocking voltages require long gates and large opening channels (large channel length to opening ratios) and reduced channel doping levels to limit the influence of V_{DS} on the channel depletion regions and prevent the space charge limited current. Also high blocking voltages require large drains (drift regions) with low doping levels to support the large potential drop without avalanche breakdown. Figures 2b-c heuristically illustrate the channel carrier concentrations as a percentage of the undepleted channel carrier concentration for V_{GS} equal to -3 volts and with V_{DS} below the blocking voltage and above the blocking voltage, respectively.

### VFET applications

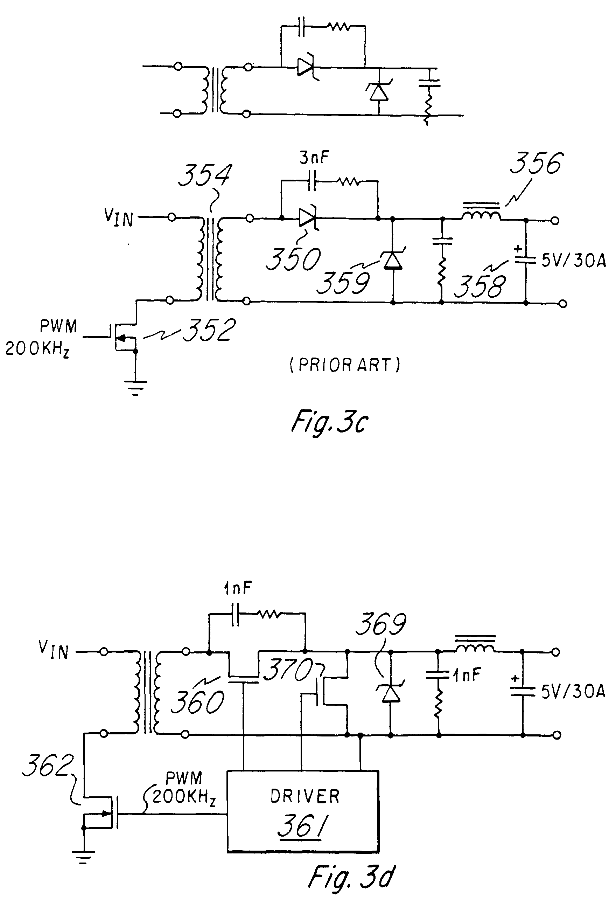

VFET 100 provides high frequency switching by low gate capacitance and low gate resistance through high gate doping levels and low channel doping levels plus small gate dimensions. Figure 3a heuristically shows multiple VFET 100s with their drains all connected to a power supply V_{DD} at +5 volts, with their sources connected to various devices 301, 302, ... 310, and with their gates driven by controller 320. Thus controller 320 controls the power supply to each of devices 301, 302, ... 310. Because VFETs 100 require a negative gate voltage to turn off, controller 320 has charge pump 330 to provide -3 volts. Both controller 320 and charge pump 330 could be CMOS circuits. The arrangement of Figure 3a could be employed in battery powered systems such as portable computers where the devices 301, 302, ... 310 would be items such as disk drives, keyboards, screens, CPUs, modems, and so forth with controller software controlled and interrupt driven to turn off all items not in use but quickly turn on items upon demand for use. Such power management will extend the charge life of a battery operating the portable computer, and the low voltage levels (e.g., down to 3.3 or even 1.5 volts) require a low R_{ON} plus the high CPU frequencies (50 MHz) require rapid power switching.

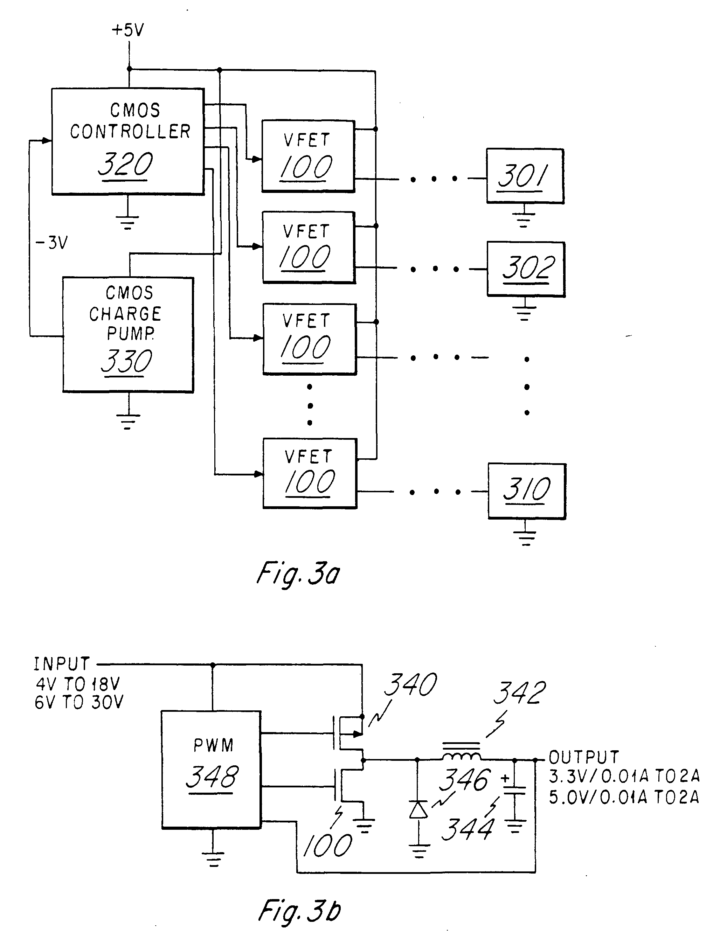

Figure 3b shows a preferred embodiment switching voltage regulator including p-channel FET 340, lowpass filter made of inductor 342 and capacitor 344, free-wheeling diode 346, VFET 100, and pulse width modulator plus controller 348. This regulator has the "buck" topology and basically operates as follows. Controller 348 switches FET 340 at a fixed frequency (e.g., 100 KHz) and senses the output voltage to control the duty cycle of the switching of FET 340; this feedback sets the output DC voltage. The lowpass filter filters the resulting square wave from FET 340 to produce a ripple free DC output. Controller 348 includes a charge pump to generate negative gate voltage for VFET 100 and turns on VFET 100 when FET 340 is turned off; thus VFET 100 provides a low resistance path to ground and prevents the output node of FET 340 from going negative during the portion of the switching cycle in which FET 340 is turned off. Free-wheeling diode 346 parallels VFET 100 and provides the same function; however, free-wheeling diode 346 would cause a diode voltage drop, and without VFET 100 the average output DC current would pass through free-wheeling diode to cause power losses. VFET 100 provides a lower resistance path for the average DC current and eliminates the diode voltage drop and its attendant power losses.

Figure 3c illustrates a known DC-DC converter including a Schottky diode 350 for rectification. The converter operates in somewhat the same manner as the regulator of Figure 3b: a pulse width modulator switches n-channel FET 352, and transformer 354 steps up (or down) the voltage of the resulting square wave. The lowpass filter made of inductor 356 and capacitor 358 filters the rectified square wave, and free-wheeling diode 359 prevents an overly negative filter input node. Figure 3d shows a preferred embodiment DC-DC conveter with synchronous rectification by VFET 360 driven by driver 361 to be synchronized with the switching of FET 362 and with VFET 370 parallel free-wheeling diode 369. The converter of Figure 3d operates analogous to the converter of Figure 3c but with rectifying diode 350 replaced by the synchronous VFET 360 to avoid the diode voltage drop and attendant power losses and also with VFET 370 providing a low resistance path parallel free-wheeling diode 369 (analog of diode 359) to avoid its power losses.

### First preferred embodiment method of fabrication

A preferred embodiment method of fabrication of VFET 100 for low voltage operation (a blocking voltage of 20 volts for a gate-to-source bias of -3 volts) uses a low resistivity substrate and backside drain contact and includes the following steps:
(a) Begin with a 637 µm (25-mil) thick (100)-oriented (to ±0.5°) GaAs wafer n++ doped with silicon to a level of about 2-4 x 10¹⁸ atoms/cm³. The substrate has true (100) orientation and does not have an orientation tilted 2° from (100) as is typically done to insure smoother epitaxial layer growth. Epitaxially grow by metalorganic chemical vapor deposition (MOCVD) the following layers of GaAs:

| Thickness | Doping type | Atomic concentration |
|---|---|---|
| 1.0 µm | n++ | 2 x 10¹⁸/cm³ |
| 1.0 µm | n- | 3 x 10¹⁶/cm³ |
| 0.3 µm | p++ | 1 x 10²⁰/cm³ |

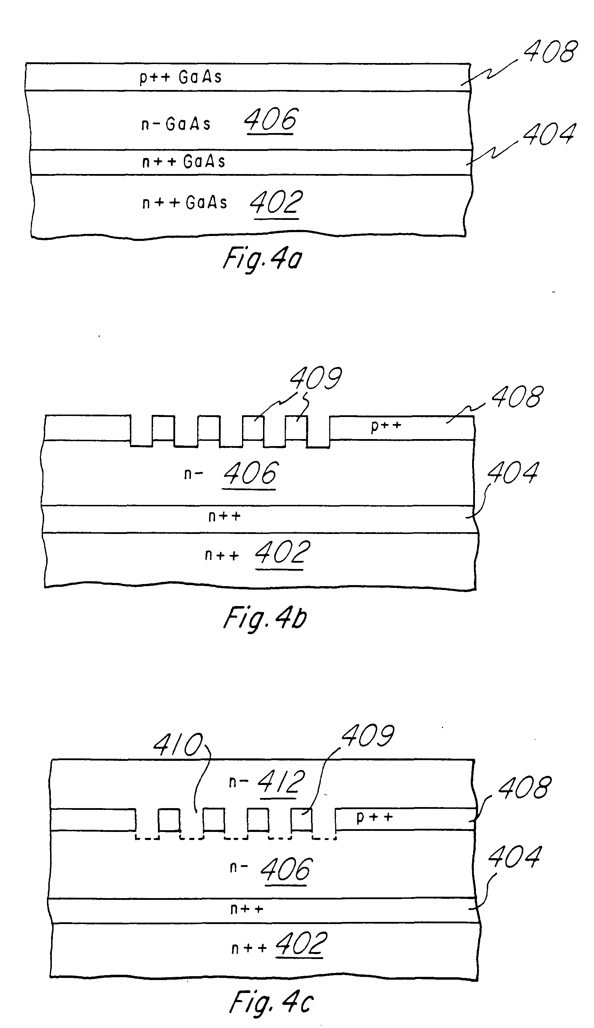

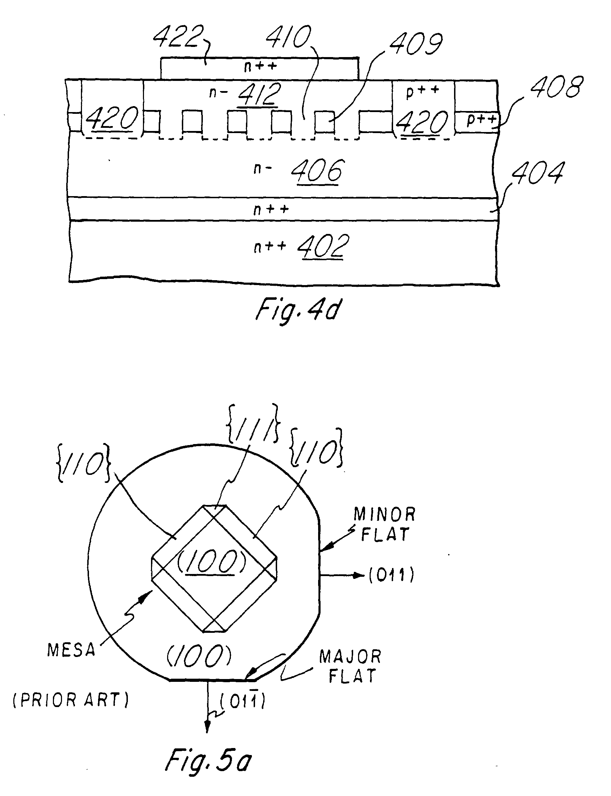

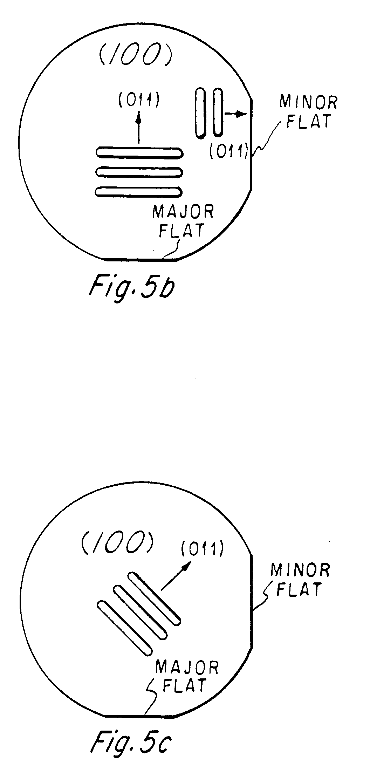

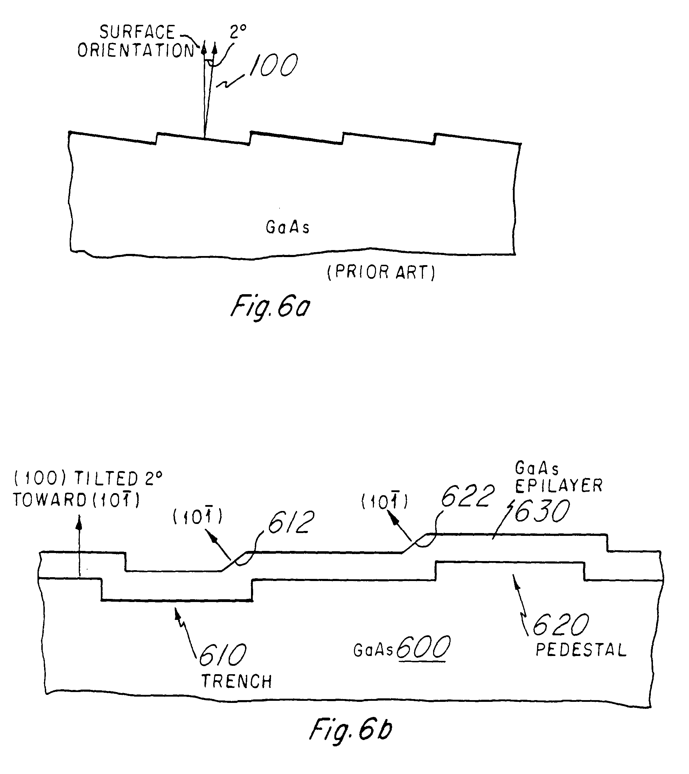

The MOCVD uses trimethyl gallium (or equivalent such as triethyl gallium) and arsine (or equivalent such as tertiarybutyl arsine or trimethyl arsine) plus disilane (or equivalent) for n-type doping and CCl₄ (or equivalent) for p-type doping. See Figure 4a for a cross sectional elevation view showing substrate 402, n++ epilayer 404, n- epilayer 406, and p++ gate layer 408.
(b) Spin on photoresist and pattern it to define 50 gate fingers 409, and then etch with an electron cyclotron resonance (ECR) chlorine-based plasma etch using the patterned photoresist as the etch mask. See Figure 4b; the channel regions between adjacent gate fingers 409 resemble a series of parallel slots in epilayer 408. The gate fingers are 0.3 µm long by 0.5 µm thick by 50-100 µm wide with 0.5 µm channel openings between adjacent gate fingers. The gate fingers all connect to the surrounding region in p++ layer 408. Overetching removes about 0.1 µm of n- layer 406. The preferred embodiment method of fabrication aligns the gate sidewalls with particular crystal planes; Figures 5a-b and the accompanying discussion details this alignment. The gate finger thickness minimum depends upon the resistivity of layer 408 , and the channel region opening maximum derives from the gate bias for maximum blocking voltage plus the doping level of the channel region. A higher breakdown voltage (about 50 volts) version of VFET 100 would use 0.7 µm channel opening with a n- doping level of 1 x 10¹⁶/cm³. Note that locally trenches between gate fingers can also be viewed as gate finger pedestals on an underlying plane. A larger channel length would increase the blocking voltage up to breakdown limits. The channel length can be varied from 0.1 µm to greater than 1 µm.
(c) Epitaxially grow an n- GaAs layer both to fill the spaces (channel regions 410) between the gate fingers and to continue to form source 412 of thickness 1.0 µm. The spaces between the gate fingers fill by growth both from the bottom of the spaces (layer 406) and from the vertical sidewalls. Of course, growth from the top of layer 408 occurs during this filling, and the pattern of the gate fingers is lost and the surface becomes essentially planar after about 0.5 µm due to the on-axis orientation. The epilayer has in situ doping with silicon to a level of 3 x 10¹⁶ atoms/cm³. See Figure 4c. The lack of tilt in the orientation of substrate 402 affects the quality of the interface between the original gate sidewalls and the channel region filling newly grown GaAs material. Figures 6a-b and the accompanying discussion below indicate the tilt effect.
(d) Implant Be to make p++ connection 420 from etched p++ epilayer 408 to the surface of epilayer as shown in Figure 1. (In place of the p++ implant a mesa etch down to layer 408 could be done.) Also, grow and pattern n++ epilayer 422 to make contact to n- source 412. Addition of metal contacts, encapsulation, and packaging completes a basic discrete VFET suitable for low voltage power regulation. Figure 4d illustrates the essential structure. Metal contacts to the n+ GaAs for source and drain may be made of an alloy such as PdGeIn, AuGeNi, PdGe, TiPtAu (if layer 422 is n++ InGaAs), and so forth, and the p++ metal contact may be an alloy such as AuZn, AuBe, and AuMn.

### Gate orientation

Figure 5a shows a standard (100)-oriented GaAs wafer in plan view and illustrates the major and minor flats which are oriented 45° to the [010] and [001] directions and represent (011) and (01-1) oriented cleavage planes. An anisotropic wet etch such as H₂SO₄, H₂O₂, and H₂O in the ratio 1:8:40 preferentially does not etch (111)Ga planes. Thus a GaAs wafer subjected to an anisotropic wet etch with square etch mask leads to a raised mesa having face orientations as illustrated. Note that the wafer surface orientation tyically has a 2° tilt from precisely (100) for good growth of thick epilayers.

When gate layer 408 has gate fingers 409 formed as elongated regions parallel to either the major or minor flat of substrate 402 (see heuristic Figure 5b in which the gate finger sidewalls are perpendicular to the plane of the Figure), then plasma etching yields gate sidewalls as {110} planes. These are the cleavage planes and the typical orientation. However, with this orientation for the gate finger sidewalls, the in situ doping MOCVD growth from the sidewalls incorporates the silicon dopants during growth of {110} or higher index planes and this leads to VFETs with poor performance which may be due to the silicon (which is an amphoteric dopant) also acting as an acceptor and yielding p type channel doping or the growth on {110} and higher index planes creating much higher crystal defect levels than growth on {100} planes. Such an incorrect doping or high defect levels in the portion of the channel abutting the gate smears out the p-n junction or provides leakage current paths and leads to poor depletion region control and low voltage gain (or low DC blocking voltage).

Preferred embodiment (010) or (001) orientation of the gate finger sidewalls as shown in Figure 5c yields incorporation of the in situ silicon dopants during {100} plane growth and donor doping throughout the channel regions. In effect, the sidewalls have the same orientation as the original substrate. Of course, control of surface orientation to within 5° may be difficult for the sidewalls due to etch irregularities, but close to {100} will just be a tilted {100} plane and yield the proper donor silicon dopant incorporation.

### Substrate tilt

Figure 6a illustrates in cross sectional elevation view the typical 2° tilt of the (100) orientation with atomic level terracing of a GaAs substrate for epitaxial growth. The atomic level terracing promotes smooth epilayer growth on a planar surface, whereas epilayer growth on untilted (100) surfaces has less uniform nucleation and yields slight ripples on the order of a few 1/100 µm (hundred angstroms) in height after 1-2 µm of epilayer growth. The surface roughness for precise (100) oriented GaAs surfaces increases with epilayer thickness up to about 5 µm and then appears to saturate. Note that a 2° tilt with a crystal unit cell dimension of about 0.565 µm (5.65 Å) yields terrace widths of roughly 0.01-0.02 µm (100-200 Å).

However, for the growth in step (c) to fill the spaces between the gate fingers, the 2° tilt must be avoided. In fact, it has been found that epitaxial growth to fill trenches and overgrow pedestals on a 2° tilted (100) surface leads to facets as illustrated in cross sectional elevation view by Figure 6b. In particular, 0.7 µm thick epilayer 630 grown on substrate 600 with 0.5 µm deep and 4 µm wide trench 610 and 0.5 µm high and 4 µm wide pedestal 620 (both having sidewalls with essentially (100) orientation as described in the preceding section) led to ledge 612 in trench 610 and ledge 622 at pedestal 620. For a (100) oriented substrate with a surface orientation vector tilted in the (10-1) direction the ledges also have an orientation of (10-1). A ledge growth in the channel regions of a VFET leads to poor performance which may arise from crystal defects due to higher index plane growth (growth on the ledges) or incorrect dopant incorporation as described in the Sidewall orientation section. Also, alignment marks (trenches or pedestals) for aligning subsequent etch masks appear shifted in epilayer 630 due to the ledges, and this complicates the fabrication process.

Consequently, the preferred embodiment uses a precisely (100) oriented (within a tolerance of 0.5°) substrate to avoid the ledges during overgrowth. This provides uniform filing of the channel between the gate fingers and uniform doping type in the channel. The use of untilted (100) oriented substrates of the preferred embodiment also avoids alignment mark shifting.

### Second preferred embodiment VFET

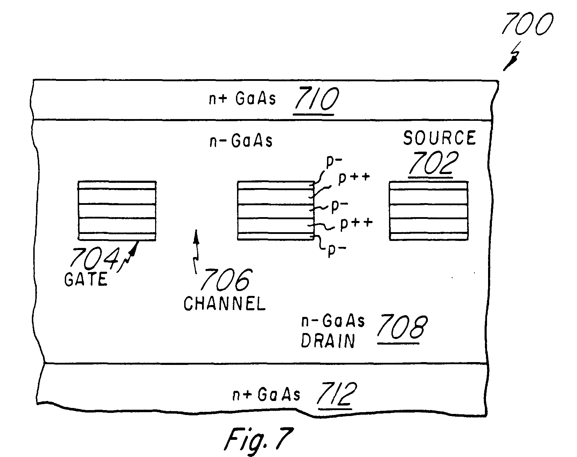

Figure 7 shows in cross sectional elevation view a second preferred embodiment VFET, generally denoted by the reference numeral 700, made of GaAs and including n doped source 702, p++/p- doped layered gate 704 in the form of parallel fingers with n doped channel regions 706 between successive gate fingers, n doped drain 708 including a drift region, n+ doped source contact 710 and n+ doped drain contact 712. VFET 700 resembles VFET 100 except for layered gate 704 which includes alternating layers of p++ and pdopings. VFET 700 has the following dimensions: gate and channel region length 0.4 µm, gate finger breadth 0.5 µm, channel region opening 0.5 µm, source length 1 µm, and drain length 1 µm. The n- doping level of source 702, channel regions 706, and drain 708 is about 3 x 10¹⁶ silicon atoms/cm³. The carbon doping to make up gate 704 varies as follows with the 0.07 µm layer abutting the drain:

| Thickness | Doping type | Atomic concentration |
|---|---|---|
| 0.07 µm | p- | 1 x 10 ¹⁴ /cm ³ |
| 0.1 µm | p++ | 1 x 10 ²⁰ /cm ³ |
| 0.1 µm | p- | 1 x 10 ¹⁴ /cm ³ |
| 0.1 µm | p++ | 1 x 10 ²⁰ /cm ³ |
| 0.05 µm | p- | 1 x 10 ¹⁴ /cm ³ |

Carbon dopants have a very small diffusivity in GaAs, and thus such thin layers can be fabricated by MOCVD without the dopant diffusion overwhelming the layering even upon annealing.

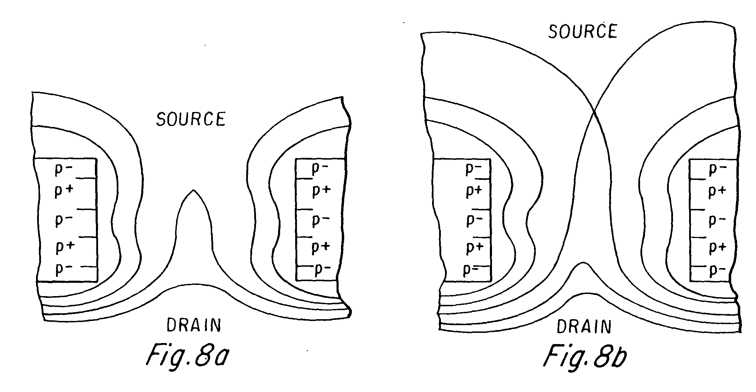

The layering of gate 704 along its length provides both low electric fields in channel regions 706 when no gate bias is applied (so the on-resistance R_{ON} is low) and high electric fields with a reverse gate bias to have high blocking voltages and large blocking gain. Figures 8a-b heuristically illustrate the equipotential lines in the channel for -2 volt gate bias V_{GS} with the drain to source voltage V_{DS} just below blocking voltage in Figure 8a and just above blocking voltage in Figure 8b. The end p- layers reduce the corner electric field magnitude to increase the gate-to-drain breakdown voltage and reduce gate capacitance, and the middle p- layer flattens the equipotential surfaces in the channel regions and extends the high field saddle toward the drain. This flatter equipotential insures better drain potential blocking. Of course, the middle p- layer could be omitted for simpler fabrication and still retain the increase in breakdown voltage; or one or both of the end p- layers could be omitted and still retain the equipotential surface flattening.

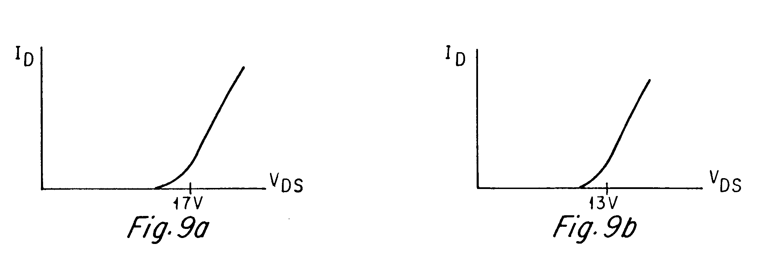

Figures 9a-b show the I-V characteristics for a gate bias of -2 volts; Figure 9a for the VFET as shown in Figure 7 and Figure 9b for interchanged source and drain.

Gate 704 could include more layers, especially for longer gates, to further flatten the equipotential surfaces and improve the blocking voltage, but longer gates increase the on resistance R_{ON}. Additionally, the gate layers could be separated by an n- layer, and then individual contacts to the gate layers could create pentodelike characteristics for the VFET.

Furthermore, the layered gate could be used without the sidewall orientation or with a tilted substrate. Lastly, a gate with doping variation along its length could be used in horizontal field effect transistors. In such a horizontal case, a buried gate region could be a series of subregions with separate doping levels.

### Third preferred embodiment VFET

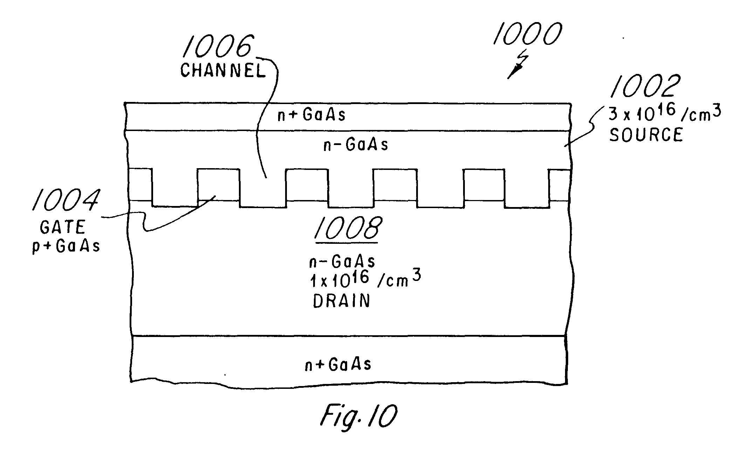

Figure 10 shows in cross sectional elevation view a third preferred embodiment VFET, generally denoted by the reference numeral 1000, made of gallium arsenide (GaAs) and including n doped source 1002, p+ doped gate 1004 in the form of parallel fingers with n doped channel regions 1006 between successive gate fingers, and n doped drain 1008. VFET 1000 differs from VFET 100 with respect to source/drain doping levels; in particular, VFET 1000 has lighter drain doping, as follows.

| Region | Doping type | Atomic concentration |
|---|---|---|
| Source | n- | 3 x 10¹⁶/cm³ |
| Channel | n- | 3 x 10¹⁶/cm³ |
| Drain | n- | 1 x 10¹⁶/cm³ |

The lighter doping of drain 1008 leads to a higher gate/substrate breakdown voltge, reduced gate/substrate capacitance, and higher blocking voltage by effectively increasing the channel length in that the channel depletion region extends deeper into the drain. It also decreases the effect of drain-source voltage V_{DS} changes on the gate blocking because the integrated charge is less on the substrate side. Further, a channel openning of 0.8 µm with a channel doping level of 1 x 10¹⁶/cm³ has about the same blocking voltage with the same gate voltage as a channel opening of 0.4 µm with a channel doping level of 3-4 x 10¹⁶/cm³; however, the smaller channel opening with higher channel doping leads to a lower on resistance R_{ON}. Thus the difference in channel and drain doping levels yields VFETs with better performance. The p+ gate layer 1004 can also have p- layers on both source and drain sides to minimize capacitance.

### Fourth preferred embodiment VFET

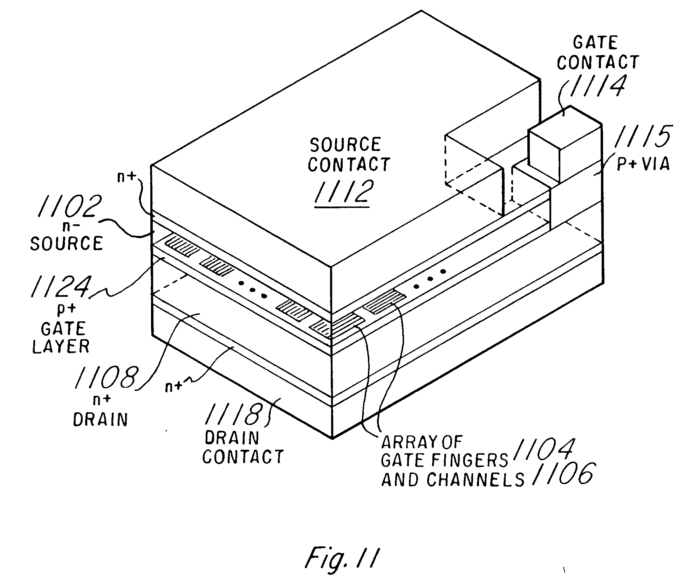

A fourth preferred embodiment VFET combines the layered gate 704 of VFET 700 with the lightly doped drain 1002 of VFET 1000. And the fourth preferred embodiment VFET adpated for low frequency use may have the simpler layout shown in heuristic perspective view in Figure 11. Figure 11 shows p+ gate layer 1124 connected by a single doped via 1115 in a corner of the integrated circuit die to metal gate contact 1114 with all of the channels 1106 between gate fingers 1104 formed in layer 1124. The gate fingers are formed in repeated areas approximately 50 µm square which limits the gate finger width and gate resistance. The use of a single gate contact 1114 reduces the die area devoted to contacts and permits a maximal portion of gate layer 1124 to be patterned as gate fingers and channels.

### Heterostructure VFET and HBT

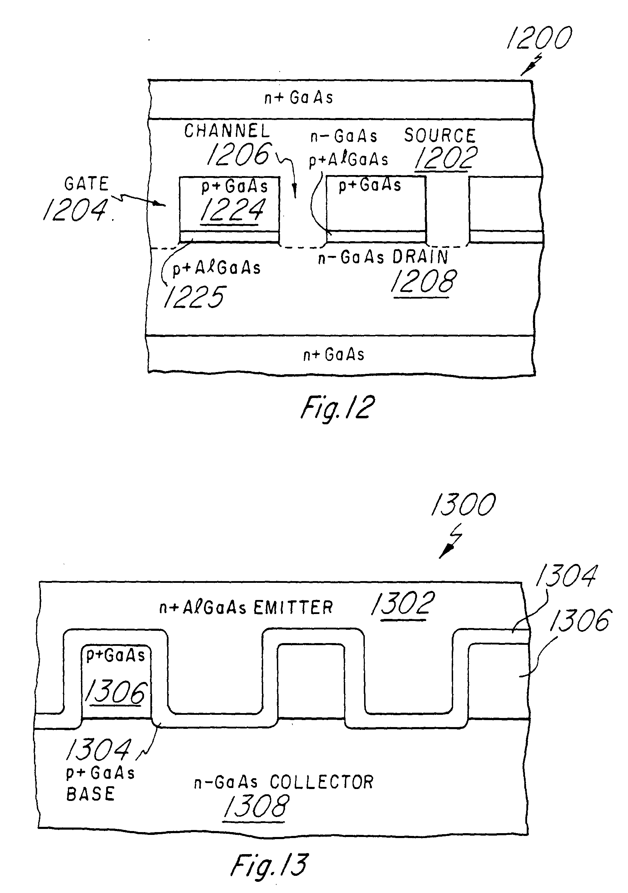

Figure 12 shows in cross sectional elevation view a portion of fifth preferred embodiment VFET 1200 which includes source 1202, gate fingers 1204, channels 1206, and drain 1208. All of these regions are made of GaAs except gate fingers 1204 are made of 0.3 µm thick p+ GaAs sublayer 1224 plus 0.05 µm thick p+ Al_{0.3}Ga_{0.7}As sublayer 1225. The incorporation of sublayer 1225 provides a heterojunction from gate 1204 to drain 1208 and thereby increase gate-drain breakdown voltage and decrease leakage current.

Alternatively, gate 1204 could be entirely p+ Al_{0.3}Ga_{0.7}As (0.3 µm thick) or be p+ Al_{0.3}Ga_{0.7}As with a thin GaAs top sublayer to aid in the n- GaAs overgrowth forming source and channels. The Al_{0.3}Ga_{0.7}As gate would also form a heterojunction with the channel and lessen gate-channel junction leakage.

Fabrication of VFET 1200 and variants proceeds as with VFET 100 with the addition of growth of a p+ Al_{0.3}Ga_{0.7}As layer; the plasma etch to form the gate fingers also etches Al_{0.3}Ga_{0.7}As. Again, the fabrication process benefits from precise (100) orientation of the wafer and (010) and (001) orientation of the gate finger sidewalls. Of course, VFET 1200 could have modulated gate doping like VFET 700 and a lightly doped drain like VFET 1000.

Figure 13 shows in cross sectional elevation view a portion of sixth preferred embodiment heterojunction bipolar transistor (HBT) 1300 which includes n+ Al_{0.3}Ga_{0.7}As emitter 1302, p+ GaAs intrinsic base 1304, p+ extrinsic base 1306, and n- GaAs collector 1308. Extrinsic base 1306 has a finger structure analogous to gate fingers of VFET 100, although the number of fingers may be much smaller and the finger size larger. In particular, extrinsic base fingers 1306 could have a cross section of 2 µm by 2 µm to minimize the base resistance, whereas intrinsic base 1304 may have a thickness of 0.1µm and a distance between adjacent extrinsic base fingers of 3 µm.

Fabrication of HBT 1300 may proceed analogous to that of VFET 100 but with the n- GaAs overgrowth forming the channels and source replaced by a 0.05 µm thick growth of p+ GaAs (in situ carbon doping) to form the intrinsic base and then a 0.5 to 1.0 µm thick n+ Al_{0.3}Ga_{0.7}As (in situ silicon doping) growth to form the emitter. The p+ GaAs overgrowth to form the intrinsic base benefits from precise (100) orientation of the wafer to avoid any ledge beginning and the (010) and (001) orientation of the base finger sidewalls just replicates. The overgrowth of n+ Al_{0.3}Ga_{0.7}As benefits from these orientations as did the n- GaAs in that the wafer orientation avoids the ledge formation and nonuniform fill of the emitter between the extrinsic base fingers and the extrinsic base sidewall orientation insures n type emitter doping. Note that silicon dopants have very small diffusivities in GaAs and Al_{0.3}Ga_{0.7}As, and thus using germanium or tin in place of silicon for the n type doping to deemphasize the base sidewall orientation will generate dopant diffusion problems.

### Modifications and advantages

The preferred embodiments may be varied in many ways while retaining one or more of the features of overgrowth on vertical sidewalls with the same crystal plane orientation as a substrate surface, overgrowth of trenches and pedestals in untilted substrates, VFET buried gate doping varying along the gate length, and varying VFET source/drain doping.

For example, the dimensions of the various components could be varied, the geometry of the channels in the VFETs or the emitters in the HBTs could be varied, other III-V materials such as GaP, InP, GaₓIn₁₋ₓP, InₓGa₁₋ₓAs, AlAs, AlₓGa₁₋ₓAs, and so forth also have the zinc blende crystal structure and overgrowth properites as GaAs. The GaAs may be an island of material grown in a recess in a silicon wafer. The p++ doping by Be to make connection to the buried gates may be replaced by Zn doping; in this case metal contacts may be alloys such as TiPtAu. Also, diamond and silicon carbide are possible materials for VFETs and HBTs.

The invention has a technical advantage of improved epilayer growth over steps in III-V substrates.

## Claims

1. A method of epitaxial overgrowth, comprising the steps of:
providing a semiconductor layer of a first III-V material, said layer having a planar surface and sidewalls, said sidewalls having crystal orientation equivalent to that of said surface; and
epitaxially growing an epilayer of a second III-V material simultaneously on said surface and on said sidewalls.

2. The method of claim 1, further comprising providing said III-V compound as gallium arsenide containing dopants.

3. The method of claim 1 or claim 2, further comprising forming said surface having about a (100) orientation; and forming said sidewalls to be sidewalls of trenches which extend from said surface into said layer.

4. The method of any preceding claim, further comprising forming:
said layer having p-type doping adjacent said surface and
n-type doping away from said surface and exposed at the bottoms of said trenches.

5. The method of any preceding claim, further comprising growing:
said epilayer having n-type doping by metal organic chemical vapour deposition.

6. The method of claim 5, further comprising selecting the n-type dopant to be silicon.

7. The method of any preceding claim comprising the further steps of:
epitaxially growing a second epilayer of an n-doped third III-V material on said epilayer; and
wherein said second epilayer is made of a third III-V compound.

8. The method of claim 7, wherein:
said first III-V compound is gallium arsenide containing dopants;
said second III-V compound is gallium arsenide containing dopants; and
said third III-V compound is aluminium gallium arsenide containing dopants.

9. A vertical field effect transistor of the type including a drain (108; 708; 1008; 1108; 1208) made of a first semiconductor material, gate region (104; 704; 1004; 1104; 1204) on said drain and made of a second semiconductor material, channel region (106; 706; 1006; 1106; 1206) on said drain and abutting the gate region and made of a third semiconductor material, and a source (102; 702; 1002; 1102; 1202) on said gate region and channel region and made of a fourth semiconductor material; **characterized by**
the semiconductor materials all being III-V semiconductor materials with a surface of the drain (108; 708; 1008; 1108; 1208) having a first crystal plane orientation and the gate region (104; 704; 1004; 1104; 1204) with sidewalls substantially perpendicular to said surface and with an equivalent crystal orientation.

10. The transistor of claim 9, wherein:
said first, second, third, and fourth III-V semiconductor materials are gallium arsenide containing dopants; and
said first crystal plane orientation is (100).

11. The transistor of claim 9 or claim 10, wherein:
said gate region (104; 704; 1004; 1104; 1204) is doped p-type with carbon; and
said source, drain, and channel regions (102, 108, 106; 702, 708, 706; 1002, 1008, 1006; 1102, 1108, 1106; 1202, 1208, 1206) are doped n-type with silicon.

12. The transistor of any of claims 9 to 11. wherein:
carrier flow from said source region (102; 702; 1002; 1102; 1202), through said channel region (106; 706; 1006; 1106; 1206), and into said drain region (108; 708; 1008; 1108; 1208) is substantially perpendicular to said surface of said drain (108; 708; 1008; 1108; 1208).

13. The transistor of any of claims 9 to 12, wherein:
said gate region (104; 704; 1004; 1104; 1204) includes a plurality of parallel fingers with portions of said channel region (106; 706; 1006; 1106; 1206) between successive ones of said parallel fingers.

14. The transistor of any of claims 9 to 13, wherein:
said second III-V semiconductor material has a larger bandgap than said first III-V semiconductor material.

15. The transistor of any of claims 9 to 14, wherein:
said gate region (704; 1104; 1204) has a doping level where said gate abuts said channel region (706; 1106; 1206) varying in the direction from said source (702; 1102; 1202) to said drain (708; 1108; 1208).

16. The transistor of claim 15, wherein:
said gate region (704; 1104; 1204) includes a first subregion abutting said drain (708; 1108; 1208) and a second subregion away from said drain (708; 1108; 1208), wherein said first subregion has a doping level less than the doping level of said second subregion.

17. The transistor of claim 15, wherein:
said gate region (704; 1104; 1204) includes successive subregions S₁, S₂, ... S_{K} in the direction from said drain (708; 1108; 1208) to said source (702; 1102; 1202) with K a positive integer greater than 2, wherein the doping level of S₂ differs from that of S₁ and the doping level of S_{K-1} differs from that of S_{K}.

18. The transistor of claim 17, wherein:
K equals 3; and
the doping levels of S₁ and S₃ are equal and less than that of S₂.

19. The transistor of claim 17, wherein:
S₁ and S₃ are doped more heavily than S₂.

20. The transistor of claim 17, wherein:
K equals 5; and
the doping levels of S₁, S₃, and S₅ are less than those of S₂ and S₄.

21. The transistor of any of claims 9 to 20, wherein the drain region (1008; 1108; 1208) and the channel region (1006; 1106; 1206) have same doping type and the drain region (1008; 1108; 1208) has a doping level less than that of the channel region (1006; 1106; 1206).

22. The transistor of claim 21, wherein said drain region (1008; 1108; 1208) has a doping level one third that of the channel region (1006; 1106; 1206).

23. A heterojunction bipolar transistor, comprising:
a collector (1308) made of a first III-V semiconductor material and with a surface having a first crystal plane orientation;
extrinsic base fingers (1306) on said collector (1308) and made of a second III-V semiconductor material, said fingers (1306) with sidewalls substantially perpendicular to said surface and with an equivalent crystal orientation;
intrinsic base regions (1304) between said fingers (1306) and made of a third III-V semiconductor material; and
an emitter (1302) on said fingers and intrinsic base regions (1304) and made of a fourth III-V semiconductor material;
wherein said fourth III-V semiconductor material has a larger bandgap than said third III-V semiconductor material.

24. The transistor of claim 23, wherein:
said first, second, and third III-V semiconductor materials are gallium arsenide containing dopants;
said fourth III-V semiconductor material is aluminium gallium arsenide containing dopants; and
said first crystal plane orientation is (100).

## Patentansprüche

1. Verfahren zum epitaktischen Aufwachsen mit den Schritten:
Erzeugen einer Halbleiterschicht aus einem ersten III-V-Material, wobei die
Schicht eine ebene Oberfläche und Seitenwände aufweist, wobei die Seitenwände ein Kristallorientierung aufweisen, die der der Oberfläche entspricht; und
gleichzeitiges epitaktisches Aufwachsen einer Epitaxialschicht aus einem zweiten III-V-Material auf der Oberfläche und auf den Seitenwänden.

2. Verfahren nach Anspruch 1, bei dem ferner die III-V-Verbindung als Dotierungsmaterialien enthaltendes Galliumarsenid erzeugt wird.

3. Verfahren nach Anspruch 1 oder Anspruch 2, bei dem ferner die Oberfläche so gebildet wird, daß sie etwa eine (100)-Orientierung hat; und die Seitenwände so gebildet werden, daß sie Seitenwände von Gräben sind, die sich von der Oberfläche aus in die Schicht erstrecken.

4. Verfahren nach einem der vorhergehenden Ansprüche, bei dem ferner die Schicht mit einer p-Dotierung angrenzend an die Oberfläche und mit einer n-Dotierung entfernt von der Oberfläche sowie freiliegend an den Böden der Gräben gebildet wird.

5. Verfahren nach einem der vorhergehenden Ansprüche, bei dem ferner das Aufwachsen der Epitaxialschicht mit n-Dotierung durch metallorganische chemische Dampfabscheidung erfolgt.

6. Verfahren nach Anspruch 5, bei dem ferner das n-Dotierungsmaterial als Silizium gewählt wird.

7. Verfahren nach einem der vorhergehenden Ansprüche, mit den weiteren Schritten:
epitaktisches Aufwachsen einer zweiten Epitaxialschicht aus einem n-dotierten dritten III-V-Material auf der Epitaxialschicht; und
wobei die zweite Epitaxialschicht aus einer dritten III-V-Verbindung gebildet wird.

8. Verfahren nach Anspruch 7, bei dem
die erste III-V-Verbindung Dotierungsmaterialien enthaltendes Galliumarsenid ist;
die zweite III-V-Verbindung Dotierungsmaterialien enthaltendes Galliumarsenid ist; und
die dritte III-V-Verbindung Dotierungsmaterialien enthaltendes Aluminium-Galliumarsenid ist.

9. Vertikaler Feldeffekttransistor des Typs mit einer Drain-Zone (108; 708; 1008; 1108; 1208) aus einem ersten Halbleitermaterial, einer Gate-Zone (104; 704; 1004; 1104; 1204) auf der Drain-Zone aus einem zweiten Halbleitermaterial, einer Kanal-Zone (106; 706; 1006; 1106; 1206) auf der Drain-Zone angrenzend an die Gate-Zone aus einem dritten Halbleitermaterial, sowie einer Source-Zone (102; 702; 1002; 1102; 1202) auf der Gate-Zone und der Kanal-Zone aus einem vierten Halbleitermaterial,
**dadurch gekennzeichnet,**
**daß** die Halbleitermaterialien alle III-V-Halbleitermaterialien sind, wobei eine Oberfläche der Drain-Zone (108; 708; 1008; 1108; 1208) eine erste Orientierung der Kristallebene hat und die Gate-Zone (104; 704; 1004; 1104 ; 1204) Seitenwände aufweist, die im wesentlichen senkrecht zu der Oberfläche verlaufen und eine entsprechende Kristallorientierung aufweisen.

10. Transistor nach Anspruch 9, bei dem:
das erste, das zweite, das dritte und das vierte III-V-Halbleitermaterial Dotierungsmaterialien enthaltendes Galliumarsenid sind; und daß die erste Orientierung
der Kristallebene (100) ist.

11. Transistor nach Anspruch 9 oder Anspruch 10, bei dem:
die Gate-Zone (104; 704; 1004; 1104; 1204) mit Kohlenstoff p-dotiert ist; und
die Source-, Drain-, und Kanal-Zonen (102, 108, 106; 702, 708, 706; 1002, 1008, 1006; 1102, 1108, 1106; 1202, 1208, 1206) mit Silizium n-dotiert sind.

12. Transistor nach einem der Ansprüche 9 bis 11, bei dem:
der Ladungsträgerfluß von der Source-Zone (102; 702; 1002; 1102; 1202) durch die Kanal-Zone (106; 706; 1006; 1106; 1206) und in die Drain-Zone (108; 708; 1008; 1108; 1208) im wesentlichen senkrecht zu der Oberfläche der Drain-Zone
(108; 708; 1008; 1108; 1208) verläuft.

13. Transistor nach einem der Ansprüche 9 bis 12, bei dem:
die Gate-Zone (104; 704; 1004; 1104; 1204) mehrere parallele Finger aufweist, wobei Abschnitte der Kanal-Zone (106; 706; 1006; 1106; 1206) zwischen aufeinanderfolgenden parallelen Fingern liegen.

14. Transistor nach einem der Ansprüche 9 bis 13, bei dem:
das zweite III-V-Halbleitermaterial einen größeren Bandabstand als das erste III-V-Halbleitermaterial hat.

15. Transistor nach einem der Ansprüche 9 bis 14, bei dem:
die Gate-Zone (704; 1004; 1104; 1204) dort, wo die Gate-Zone an die Kanal-Zone (706; 1106; 1206) angrenzt, einen Dotierungspegel hat, der sich in der Richtung von der Source-Zone (702; 1102; 1202) zu der Drain-Zone (708; 1108; 1208) ändert.

16. Transistor nach Anspruch 15, bei dem:
die Gate-Zone (704; 1104; 1204) eine erste, an die Drain-Zone (708; 1108; 1208) angrenzende Unterzone sowie eine von der Drain-Zone (708; 1108; 1208) entfernte zweite Unterzone aufweist, wobei die erste Unterzone einen Dotierungspegel hat, der niedriger als der Dotierungspegel der zweiten Unterzone ist.

17. Transistor nach Anspruch 15, bei dem:
die Gate-Zone (704; 1104; 1204) aufeinanderfolgende Unterzonen S₁, S₂, ... S_{K} in der Richtung von der Drain-Zone (708; 1108; 1208) zu der Source-Zone (702; 1102; 1202) aufweist, wobei K eine positive ganze Zahl größer als 2 ist, wobei der Dotierungspegel von S₂ verschieden von dem S₁ ist und der Dotierungspegel von S_{K-1} verschieden von dem von S_{K} ist.

18. Transistor nach Anspruch 17, bei dem:
K gleich 3 ist; und
die Dotierungspegel von S₁ und S₃ gleich und niedriger als der von S₂ ist.

19. Transistor nach Anspruch 17, bei dem:
S₁ und S₃ stätker dotiert sind als S₂.

20. Transistor nach Anspruch 17, bei dem:
K gleich 5 ist; und
die Dotierungspegel von S₁, S₃ und S₅ niedriger als die von S₂ und S₄ sind.

21. Transistor nach einem der Ansprüche 9 bis 20, bei dem die Drain-Zone (1008; 1108, 1208) und die Kanal-Zone (1006; 1106; 1206) den gleichen Dotierungstyp haben und die Drain-Zone (1008; 1108; 1208) einen Dotierungspegel hat, der niedriger als der der Kanal-Zone (1006; 1106; 1206) ist.

22. Transistor nach Anspruch 21, bei dem die Drain-Zone (1008; 1108; 1208) einen Dotierungspegel hat, der ein Drittel von dem der Kanal-Zone (1006; 1106; 1206) ist.

23. Bipolarer Transistor mit Heteroübergang, mit:
einem Kollektor (1308) aus einem ersten HI-V-Halbleitermaterial und mit einer Oberfläche, die eine erste Orientierung der Kristallebene aufweist; störstellenleitenden Basisfingern (1306) auf dem Kollektor (1308) aus einem
zweiten III-V-Halbleitermaterial, wobei die Finger (1306) Seitenwände aufweisen, die im wesentlichen senkrecht zu der Oberfläche verlaufen und eine ebensolche Kristallorientierung aufweisen;
eigenleitende Basis-Zonen (1304) zwischen den Fingern (1306) aus einem dritten III-V-Halbleitermaterial; und
einem Emitter (1302) auf den Fingern und den eigenleitenden Basis-Zonen (1304) aus einem vierten III-V-Halbleitermaterial;
wobei das vierte III-V-Halbleitermaterial einen größeren Bandabstand als das dritte III-V-Halbleitermaterial hat.

24. Transistor nach Anspruch 23, bei dem:
das erste, das zweite und das dritte Ill-V-Halbleitermaterial Dotierungsmaterialien enthaltendes Galliumarsenid sind;
das vierte III-V-Halbleitermaterial Dotierungsmaterial Aluminium-Galliumarsenid ist; und
die erste Orientierung der Kristallebene (100) ist.

## Revendications

1. Procédé de surcroissance épitaxiale comprenant les étapes suivantes :
fournir une couche semi-conductrice formée d'un premier matériau de type III-V, ladite couche ayant une surface plane et des parois latérales, lesdites parois latérales ayant une orientation cristalline équivalente à celle de ladite surface ; et
développer de manière épitaxiale une couche épitaxiale d'un second matériau de type III-V, simultanément sur ladite surface et sur lesdites parois latérales.

2. Procédé selon la revendication 1, comportant en outre l'apport dudit composé de type III-V fourni en tant que de l'arsénium de gallium contenant des dopants.

3. Procédé selon la revendication 1 ou 2, comportant en outre la formation de ladite surface ayant l'orientation référencée (100) ; et la formation desdites parois latérales afin qu'elles soient les parois latérales de tranchées qui s'étendent de ladite surface à l'intérieur de ladite couche.

4. Procédé selon l'une quelconque des revendications précédentes, comportant en outre la formation de ladite couche ayant un dopage de type P adjacent à ladite surface et un dopage de type N éloigné de ladite surface et exposé au-dessous desdites tranchées.

5. Procédé selon l'une quelconque des revendications précédentes, comportant en outre le développement de ladite couche épitaxiale ayant un dopage de type N obtenu par dépôt de métal par des vapeurs chimiques organiques.

6. Procédé selon la revendication 5, comportant en outre le choix du dopant de type N comme étant du silicone.

7. Procédé selon l'une quelconque des revendications précédentes, comprenant en outre les étapes suivantes :
développer de manière épitaxiale une seconde couche épitaxiale d'un troisième matériau de type III-V dopé de type N sur ladite couche épitaxiale ; et dans lequel ladite seconde couche épitaxiale est faite d'un troisième composé de type III-V.

8. Procédé selon la revendication 7, dans lequel :
ledit premier composé de type III-V est de l'arsénium de gallium contenant des dopants ;
ledit second composé de type III-V est de l'arsénium de gallium contenant des dopants ; et
ledit troisième composé de type III-V est de l'arsénium de gallium et d'aluminium contenant des dopants.

9. Transistor à effet de champ vertical du type contenant un drain (108; 708; 1008; 1108; 1208) fait d'un premier matériau semi-conducteur, une région de grille (104 ; 704 ; 1004 ; 1104 ; 1204) sur ledit drain, et fait d'un second matériau semi-conducteur, une région de canal (106 ; 706 ; 1006 ; 1106 ; 1206) sur ledit drain et contiguë à ladite région de grille et faite d'un troisième matériau semi-conducteur, et une source (102 ; 702 ; 1002 ; 1102 ; 1202) sur ladite région de grille et ladite région de canal et faite d'un quatrième matériau semi-conducteur ;
**caractérisé en ce que** les matériaux semi-conducteurs sont tous des matériaux semi-conducteurs de type III-V avec une surface du drain (108 ; 708 ; 1008 ; 1108 ; 1208) ayant une première orientation cristalline plane et la région de grille (104 ; 704 ; 1004 ; 1104 ; 1204) avec lesdites parois latérales essentiellement perpendiculaires à ladite surface et avec une orientation cristalline équivalente.

10. Transistor selon la revendication 9, dans lequel lesdits premier, second, troisième et quatrième matériaux semi-conducteurs de type III-V, sont de l'arsénium de gallium contenant des dopants ; et
ladite première orientation cristalline plane est l'orientation référencée (100).

11. Transistor selon la revendication 9 ou la revendication 10, dans lequel ladite région de grille (104 ; 704 ; 1004 ; 1104 ; 1204) a un dopage de type P avec du carbone ; et
lesdites régions de source, de drain et de canal (102, 108, 106 ; 702, 708, 706 ; 1002, 1008, 1006 ; 1102, 1108, 1106 ; 1202, 1208, 1206) sont dopées de type N avec du silicone.

12. Transistor selon l'une quelconque des revendications 9 à 11, dans lequel le flux de porteurs de charges de ladite région source (102 ; 702 ; 1002 ; 1102 ; 1202), à travers ladite région de canal (106 ; 706 ; 1006 ; 1106 ; 1206) et à l'intérieur de ladite région de drain (108 ; 708; 1008; 1108; 1208), est essentiellement perpendiculaire à ladite surface dudit drain (108 ; 708 ; 1008 ; 1108 ; 1208).

13. Transistor selon l'une quelconque des revendications 9 à 12, dans lequel ladite région de grille (104 ; 704 ; 1004 ; 1104 ; 1204) inclut une pluralité de bandes parallèles avec des portions de ladite région de canal (106 ; 706 ; 1006 ; 1106 ; 1206) entre des bandes successives desdites bandes parallèles.

14. Transistor selon l'une quelconque des revendications 9 à 13, dans lequel ledit second matériau semi-conducteur de type III-V a une largeur de bande interdite supérieure audit premier matériau semi-conducteur de type III-V.

15. Transistor selon l'une quelconque des revendications 9 à 14, dans lequel ladite région de grille (704 ; 1104 ; 1204) a un niveau de dopant là où ladite grille est contiguë à ladite région de canal (706 ; 1106 ; 1206) variant dans la direction s'étendant de ladite source (702 ; 1102 ; 1202) vers ledit drain (708 ; 1108 ; 1208).

16. Transistor selon la revendication 15, dans lequel ladite région de grille (704 ; 1104 ; 1204) comprend une première sous-région contiguë audit drain (708; 1108; 1208) et une seconde sous-région éloignée dudit drain (708 ; 1108 ; 1208), dans lequel ladite première sous-région a un niveau de dopage inférieur au niveau de dopage de ladite seconde sous-région.

17. Transistor selon la revendication 15, dans lequel ladite région de grille (704 ; 1104 ; 1204) inclut des sous-régions successives S₁, S₂,...Sₖ s'étendant dans la direction dudit drain (708 ; 1108 ; 1208) vers ladite source (702 ; 1102 ; 1202) avec K étant un entier positif supérieur à 2, dans lequel le niveau de dopage de S₂ est différent de celui de S₁ et le niveau de dopage de S_{K-1} est différent de celui de S_{K}.

18. Transistor selon la revendication 17, dans lequel K vaut 3 ; et les niveaux de dopage de S₁ et S₃ sont identiques et inférieurs à celui de S₂.

19. Transistor selon la revendication 17, dans lequel S₁ et S₃ sont dopés plus lourdement que S₂.

20. Transistor selon la revendication 17, dans lequel K vaut 5 ; et
les niveaux de dopage de S₁, S₃ et S₅ sont inférieurs à ceux de S₂ et S₄.

21. Transistor selon l'une quelconque des revendications 9 à 20, dans lequel la région de drain (1008 ; 1108 ; 1208) et la région de canal (1006 ; 1106 ; 1206) ont le même type de dopage et la région de drain (1008 ; 1108 ; 1208) a un niveau de dopage inférieur à celui de la région de canal (1006 ; 1106 ; 1206).

22. Transistor selon la revendication 21, dans lequel ladite région de drain (1008 ; 1108 ; 1208) a un niveau de dopage égal à un tiers de celui de la région de canal (1006 ; 1106 ; 1206).

23. Transistor bipolaire à jonction hétérogène comprenant un collecteur (1308) fait d'un premier matériau semi-conducteur de type III-V et avec une surface ayant une première orientation cristalline plane ;
des bandes de base extrinsèques (1306) sur ledit collecteur (1308) sont faites d'un second matériau semi-conducteur de type III-V, lesdites bandes (1306) et lesdites parois latérales étant essentiellement perpendiculaires à ladite surface et avec une orientation cristalline équivalente ;
des régions de base intrinsèques (1304) entre lesdites bandes (1306) et faites d'un troisième matériau semi-conducteur de type III-V ; et
un émetteur (1302) sur lesdites bandes et lesdites régions de base intrinsèques (1304), et fait d'un quatrième matériau semi-conducteur de type III-V ;
dans lequel ledit quatrième matériau semi-conducteur de type III-V a une largeur de bande interdite supérieure à celle dudit troisième matériau semi-conducteur de type III-V.

24. Transistor selon la revendication 23, dans lequel lesdits premier, second et troisième matériaux semi-conducteurs de type III-V sont de l'arsénium de gallium contenant des dopants ;
ledit quatrième matériau semi-conducteur de type III-V est de l'arsénium de gallium et d'aluminium contenant des dopants ; et
ladite orientation cristalline plane est celle référencée (100).
